# EUROPEAN PATENT SPECIFICATION

(11) **EP 3 742 609 B1**
(45) Date of publication and mention of the grant of the patent: **12.02.2025**
(21) Application number: 19176021.4
(22) Date of filing: 22.05.2019
(51) Int. Cl.: H03F 3/72, H03F 1/02, H03F 1/52, H03F 3/21, H03F 3/24, H03F 3/60

(54) **METHOD OF OPERATING AN AMPLIFIER DEVICE AND AMPLIFIER DEVICE**
VERFAHREN ZUM BETREIBEN EINER VERSTÄRKERVORRICHTUNG UND VERSTÄRKERVORRICHTUNG
PROCÉDÉ DE FONCTIONNEMENT D'UN DISPOSITIF D'AMPLIFICATEUR ET DISPOSITIF D'AMPLIFICATEUR

(43) Date of publication of application: 25.11.2020
(73) Proprietor: Rohde & Schwarz GmbH & Co. KG, 81671 München (DE)
(72) Inventor: Göritz, Raimon, 81671 München (DE); Laurisch, Knut, 81671 München (DE)
(74) Representative: Novagraaf Group

(56) References cited:
- US-A- 4 439 740
- US-A- 4 780 685
- US-A- 4 782 313
- US-A- 4 965 530
- US-A- 5 872 491

## Description

The invention relates to a method of operating an amplifier device. Further, the invention relates to an amplifier device.

In the state of the art, broadband amplifier (BBA) devices are known that relate to broadband power combining techniques. The broadband amplifier devices typically comprise several low power amplifier circuits wherein the output powers of the respective low power amplifier circuits are combined in a broadband environment and, thus, forming the broadband amplifier device. Accordingly, the broadband amplifier device comprises several amplifier stages established by the low power amplifier circuits.

The broadband amplifier devices known in the state of the art also comprise a load resistor besides the several amplifier stages, which is also called load-balancing resistor. The load resistor is used in case of a failure occurring in one of the several amplifier stages, namely the low power amplifier circuits. In fact, a part of the power processed by the broadband amplifier device is directed into the load resistor in order to convert the power into heat that dissipates. Accordingly, the load resistor used by the broadband amplifier device has to convert high power into heat in case of a faulty amplifier stage, as the respective output power of the faulty amplifier stage is forwarded to the load resistor. Therefore, the load resistor has to withstand high powers, which makes the load resistor expensive. In addition, a cooling of the load resistor is necessary in order to reduce the heat of the load resistor in case of a failure to avoid failure of the load resistor itself.

Thus, the broadband amplifier device is expensive, as the load resistance used has to handle high powers in case of failure of one of the amplifier stages. Further, the costs increase since a separate cooling of the load resistor is necessary. Moreover, the (radio frequency) energy is wasted by the load resistor, as it is converted into heat that dissipates.

US 4 439 740 A shows a corporate amplifier having a plurality of amplifier modules that are integrated in respective lines by means of relays which are controlled by a fault signal.

In US 5 872 491 A, a spring-loaded switching member for interrupting a line is shown.

US 4 965 530 A discloses an amplifier arrangement with a plurality of amplifier modules, wherein an electromagnet is shown that grounds a line.

In US 4 780 685 A, a power combiner is shown that comprises manually operated coaxial connectors and switches.

US 4 782 313 A shows a switch arrangement for interrupting a signal flow on a microstrip transmission line by means of an electromagnetically actuated conductive plunger that is supported by a conductive diaphragm spring connected to the ground plane.

Accordingly, there is a need for an energy-efficient amplifier device that can be manufactured in a cost-efficient manner.

The invention provides a method of operating an amplifier device having at least two parallel amplifier stages, with the following steps:
- Generating an error signal in case of failure of at least one amplifier stage that is coupled to a rest of the amplifier device via a coupling interface in a releasable manner such that the amplifier stage is galvanically separable from the rest of the amplifier device, wherein the error signal controls a switching unit that comprises a stepping motor, and
- Separating the at least one faulty amplifier stage galvanically from the rest of the amplifier device by means of the stepping motor causing a movement that provides the galvanic separation of the faulty amplifier stage since a part of the amplifier stage is moved by the stepping motor, wherein the part has the coupling interface.

Further, the invention provides an amplifier device comprising at least a first amplifier stage and a second amplifier stage. Both amplifier stages are parallel to each other. The amplifier device comprises an error-monitoring unit configured to monitor the status of the amplifier stages. The error-monitoring unit is configured to generate an error signal in case of failure of at least one amplifier stage. The amplifier stages each are coupled to a rest of the amplifier device via a coupling interface in a releasable manner such that the amplifier stages are galvanically separable from the rest of the amplifier device. The amplifier device comprises a switching unit that is assigned to at least one of the coupling interfaces, wherein the error signal controls the switching unit that comprises a stepping motor that is configured to cause a movement that provides the galvanic separation of the faulty amplifier stage since a part of the amplifier stage is moved by the stepping motor, wherein the part has the respective coupling interface.

Accordingly, the impedance matching of the amplifier device can be adapted in case of failure of at least one amplifier stage, as the faulty amplifier stage is galvanically separated from the rest of the amplifier device. The failure of the at least one amplifier stage is monitored by means of the error-monitoring unit such that the error signal is generated when the error-monitoring unit identifies an error or rather failure of the at least one amplifier stage.

The rest of the amplifier device comprises the other amplifier stages, namely the non-faulty ones or rather the operable ones, as well as a main component, for instance a combining portion to which the amplifier stages are coupled via the respective coupling interfaces.

In the state of the art, an amplifier device having two amplifier stages of a certain power, for instance 50 W resulting in 100 W total power. In case of failure of one of the amplifier stages, half of the total power fails, for instance 50 W. A quarter of the total power, for instance 25 W, is converted into heat in the load resistor, whereas another quarter of the entire power, for instance 25 W, reaches a device connected to the amplifier device, for instance an antenna.

In contrast to the state of the art, the inventive amplifier device as well as the inventive method of operating an amplifier device ensure that half of the total power is forwarded to the device connected to the amplifier device, for instance the antenna. In fact, the faulty amplifier stage is separated galvanically from the rest of the amplifier device such that half of the total power fails, for instance 50 W, whereas the portion of the power converted into heat by the load resistance is zero, namely 0 W. Thus, a load resistance is no more necessary in the amplifier device according to the invention. Further, active cooling of the load resistance is not necessary anymore, as no load resistance is present.

Accordingly, the amplifier device may be established free of any load resistance and/or cooling.

Particularly, the amplifier device is a high power amplifier device processing radio frequency signals or rather high frequency signals.

The galvanic separation ensures that the respective signals cannot be processed by the amplifier device.

Further, the galvanic separation may relate to a mechanical separation, which means that no mechanical connection is provided between the faulty amplifier stage and the rest of the amplifier device.

Generally, the amplifier device is a broadband amplifier device that relates to broadband power combining techniques. In fact, the power outputs of the amplifier stages, for instance the low power amplifier circuits, are combined by the amplifier device.

In other words, the invention provides a power combiner established by the amplifier device. For instance, the power combiner is a Wilkinson-Combiner or a radial combiner.

The error signal controls the switching unit that separates the at least one faulty amplifier stage galvanically from the rest of the amplifier device. In other words, the amplifier device comprises the switching unit that is assigned to at least one of the coupling interfaces. Thus, the switching unit may interact with the amplifier stages, particularly their coupling interfaces.

Hence, the error signal is used by the amplifier device in order to automatically separate the at least one faulty amplifier stage from the rest of the amplifier device by means of the switching unit. Thus, no manual interaction of a user of the amplifier device is required.

Particularly, the switching unit is connected with the error-monitoring unit. For instance, the error-monitoring unit is configured to control the switching unit. Thus, a signal can be transmitted from the error-monitoring unit to the switching unit in order to control the switching unit. Put another way, the error-monitoring unit identifies the occurrence of a failure of at least one amplifier stage and, thus, controlling the switching unit in order to galvanically separate the at least one faulty amplifier stage from the rest of the amplifier device. Thus, the galvanic separation is done in an automatic manner, as the error-monitoring unit automatically controls the switching unit in an appropriate manner.

However, the at least one faulty amplifier stage may also be separated galvanically from the rest of the amplifier device in a manual manner in addition to the automatic separation. Thus, the error signal indicates to the user of the amplifier device that at least one amplifier stage has an error or rather failure. In other words, the error signal enables the user to identify the respective amplifier stage so as to galvanically separate the faulty amplifier stage manually from the rest of the amplifier device in addition to the automatic separation.

Thus, the faulty amplifier stage is separated from the rest of the amplifier device by means of the stepping motor. In case of failure, the stepping motor causes a movement that provides the galvanic separation of the faulty amplifier stage.

The stepping motor may also rotate the amplifier stages and/or a part of the amplifier device, for instance a coupling member, in order to galvanically separate the faulty amplifier stage from the rest of the amplifier device.

Another aspect provides that the switching unit comprises a rotatable coupling member to which the coupling interfaces are assigned, in particular wherein the coupling member comprises an isolated terminal. Thus, the rotatable coupling member may be rotated due to the control signal issued by the error-monitoring unit. The rotation of the coupling member results in an assignment of the at least one faulty amplifier stage with the isolated terminal such that the faulty amplifier stage is galvanically separated from the rest of the amplifier device.

The rotatable coupling member may be rotated in an automatic manner by means of the stepping motor. Hence, the stepping motor drives the rotatable coupling member so as to bring the isolated terminal in connection with the faulty amplifier stage.

In addition to the automatic rotation, the rotatable coupling member may be rotated manually by the user in order to assign the faulty amplifier stage to the isolated terminal. Thus, the faulty amplifier stage is galvanically separated from the rest of the amplifier device.

Furthermore, at least one of the amplifier stages may comprise a line, particularly a microstrip line. The respective line may be connected with a connection terminal, for instance via its coupling interface. The connection terminal may be provided by the rotatable coupling member in addition to the isolated terminal. In an initial state of the amplifier device, the lines are connected via their coupling interfaces with the corresponding connection terminals.

Only in case of failure of one of the amplifier devices, the connection is released via the respective coupling interface of the faulty amplifier stage.

Moreover, the switching unit may be assigned to the line that is partially movable, in particular wherein the switching unit is configured to move the partially movable line to galvanically separate the line from the rest of the amplifier device. Thus, the respective line assigned to the amplifier stage(s) is at least partly movable. For instance, the line has a movable tip that is assigned to the stepping motor.

The movable part of the line may be moved by the stepping motor in order to disconnect the line from the rest of the amplifier device in case of failure of the associated amplifier stage. Thus, the galvanic separation of the at least one faulty amplifier stage from the rest of the amplifier device is ensured.

The amplifier device may comprise an optical indication unit, in particular wherein the error-monitoring unit is connected with the optical indication unit. The optical indication unit is provided in order to optically indicate the occurrence of a failure by issuing an optical signal. The optical signal may be controlled by the error signal generated. Thus, a user of the amplifier device recognizes whether or not at least one of the amplifier stages has a failure, particularly which of the amplifier stages has a failure. Then, the user, in addition to the automatic separation, is enabled to (manually) separate the faulty amplifier stage from the rest of the amplifier device, for instance by simply (mechanically) disconnecting the respective amplifier stage resulting in a galvanic separation.

Hence, occurrence of the error signal may be indicated optically. Thus, an optical indication is provided by the amplifier device that enables the user of the amplifier device to recognize whether or not a failure occurs. Thus, the user is enabled to manually separate the faulty amplifier stage in a galvanic manner from the rest of the amplifier device in addition to the automatic separation. The optical indication may identify the respective amplifier stage in an unambiguous manner.

In general, the amplifier device is configured to perform a method as described above. In other words, the aspects mentioned above can be combined in any manner.

The invention will now be described with reference to preferred embodiments, which are shown in the enclosed drawings. In the drawings,
- Figure 1 shows a schematic illustration of an amplifier device, not forming part of the claimed invention, in its initial state,
- Figure 2 shows the amplifier device of Figure 1 in a failure state,
- Figure 3 shows a schematic illustration of another embodiment of the amplifier device according to the invention,
- Figure 4 shows a schematic illustration of another amplifier device, not forming part of the claimed invention,
- Figure 5 shows a detail of the amplifier device shown in Figure 4,
- Figure 6 shows the detail of Figure 5 in a side view,
- Figure 7 shows a schematic illustration of another embodiment of the amplifier device according to the invention, and
- Figure 8 shows a front view of a rotatable coupling member used by the amplifier device shown in Figure 7.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

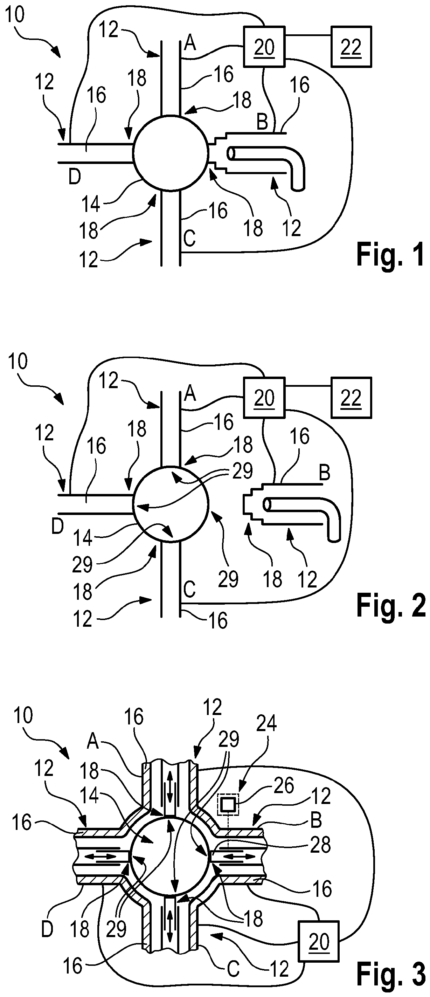

In Figure 1, a broadband amplifier device 10 is shown that comprises several amplifier stages 12.

In the shown embodiment, the amplifier device 10 has four amplifier stages indicated by A - D. As shown in Figure 1, the amplifier stages 12 are parallel to each other, as they are connected with a main component 14 of the amplifier device 10. In fact, the amplifier device 10 shown in Figure 1 relates to a radial combiner, as the respective amplifier stages 12 are orientated in a radial manner with respect to the main component 14 in which the output powers of the amplifier stages 12 are combined.

Generally, the amplifier stages 12 each comprise a line 16 via which signals are forwarded to the main component 14. Put another way, the several lines 16 are connected with the main component 14, wherein the respective lines 16 each have a coupling interface 18 via which the lines 16, namely the respective amplifier stages 12, are connected to the main component 14 of the amplifier device 10.

Furthermore, the amplifier device 10 has an error-monitoring unit 20 that is configured to monitor the status of the amplifier stages 12. For this purpose, the error-monitoring unit 20 is connected to each of the amplifier stages 12 in order to obtain status information. This is schematically shown in Figure 1.

The error-monitoring unit 20 is configured to generate an error signal in case of detection of a failure of at least one of the several amplifier stages 12.

The error-monitoring unit 20 may be connected to an optical indication unit 22 as schematically shown in Figure 1. Thus, the occurrence of a failure, namely the issuance of the error signal, is optically indicated by the optical indication unit 22 in order to inform a user of the amplifier device 10.

Then, the user is enabled to galvanically separate the faulty amplifier stage 12 from the rest of the amplifier device 10, namely the main component 14 as well as the other amplifier stages 12 being not faulty.

A shown in Figure 2, the galvanic separation may be done by mechanically disconnecting the faulty amplifier stage 12 by separating the respective line 16 from the main component 14 via the coupling interface 18 of the amplifier stage 12, via which the amplifier stage 12, namely the line 16 is connected to the rest of the amplifier device 10 in a releasable manner.

The impedance matching of the amplifier device 10 may be adapted, as the Voltage Standing Wave Ratio (VSWR) may correspond to 1 in the initial state, whereas it increases to 1.3 in the failure state.

In an embodiment shown in Figure 3, the error-monitoring unit 20 may be connected to a switching unit 24 that is assigned to the coupling interfaces 18 of the amplifier stages 12.

In the shown embodiment of Figure 3, the switching unit 24 comprises a stepping motor 26 that interacts with a part of the line 16 that is at least partially movable, namely a tip 28 of the respective line 16. In Figure 3, this is only shown for the amplifier stage 12 indicated by B. However, the switching unit 24 may be assigned to each of the amplifier stages 12.

Accordingly, each of the tips 28 of the lines 16, which comprise the respective coupling interfaces 18, is assigned to the switching unit 24, particularly the motor 26. The tips 28 can be moved forward and rearward so as to couple the amplifier stages 12 with the main component 14 having respective connection terminals 29 for the coupling interfaces 28.

Hence, the error-monitoring unit 20 is connected with the switching unit 24 such that the error-monitoring unit 20 controls the switching unit 24, particularly the motor 26, in order to galvanically separate the faulty amplifier stage 12 from the rest of the amplifier device 10 in case of failure. Thus, the respective tip 28 comprising the coupling interface 18 is moved away from the main component 14 of the amplifier device 10, particularly the respective connection terminal 29, in order to galvanically separate, namely mechanically disconnect, the faulty amplifier stage 12 from the rest of the amplifier device 10.

From Figure 3 it becomes obvious that the respective lines 16 may be established by coaxial lines having an inner conductor having the tip 28 and an outer conductor. The respective outer conductors may form an (internal) housing part of the amplifier device 10 as shown in Figure 3.

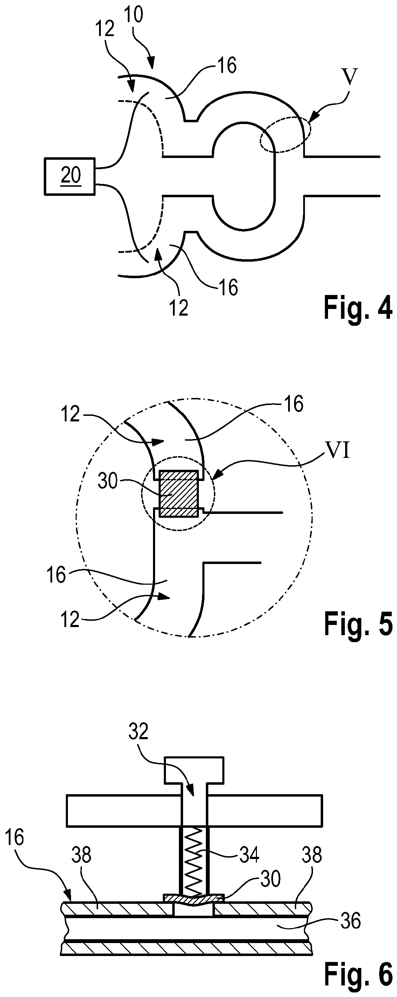

In Figures 4 to 6, another embodiment of the amplifier device 10 is shown that comprises an alternative of the switching unit 24. The respective amplifier device 10 is assigned to a Wilkinson-Combiner, as the respective lines 16 are provided by micro strip lines.

In the shown embodiment, not forming part of the claimed invention, the switching unit 24 comprises a spring-loaded switching member 30, a bayonet lock 32 as well as a spring 34. The spring 34 is assigned to both the spring-loaded switching member 30 and the bayonet lock 32.

Further, a printed circuit board 36 comprising electrically conductive material 38, for instance copper, is provided wherein a gap is provided within the electrically conductive material 38 that is bridged by the spring-loaded switching member 30 in the initial state shown. The spring-loaded switching member 30 is made of an electrically conductive material, for instance copper.

In the initial state, the spring-loaded switching member 30 is pressed via the spring 34 on the electrically conductive material 38 provided on the printed circuit board 36. Thus, a continuous electrical connection is established such that the signals provided by the amplifier stage 12 can be combined by the amplifier device 10.

In case of a failure occurring in one of the amplifier stages 12, the bayonet lock 32 may be released (manually or automatically) resulting in releasing the spring 34 and, thus, interrupting the connection established via the spring-loaded switching member 30. Accordingly, the faulty amplifier stage 12 is separated from the rest of the amplifier device 10 galvanically.

The bayonet lock 32 may be unlocked in a manual manner or automatically by means of the switching unit 24, namely a motor or any other automatically controlled module.

In general, the spring 34 may be located at different positions while ensuring a biasing force in the initial state, which acts on the spring-loaded switching member 30 so as to close the connection.

Hence, releasing the spring 34 results in the galvanic separation of the amplifier stage 12, as the electrically conductive switching member 30 is no longer connected with the electrically conductive material 38.

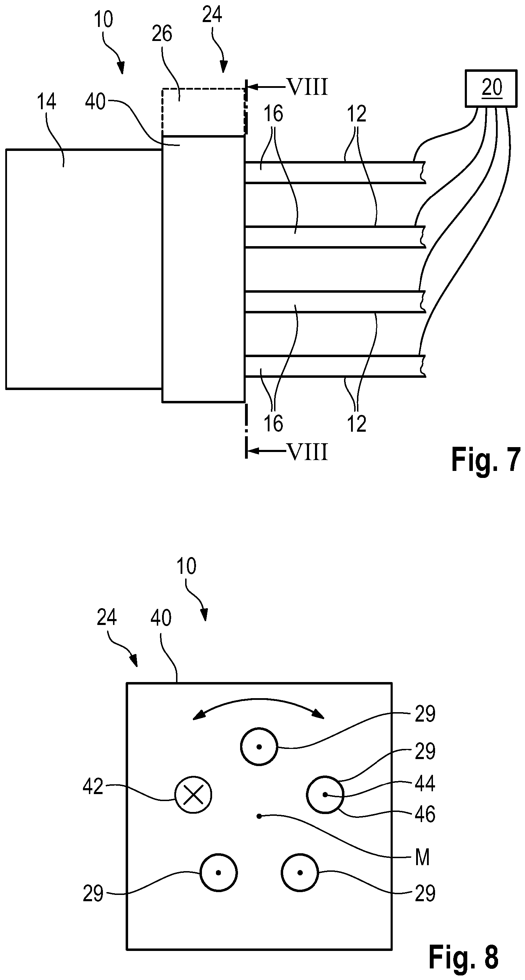

In Figures 7 and 8, another embodiment of the amplifier device 10 is shown wherein the amplifier device 10, particularly the switching unit 24, comprises a rotatable coupling member 40 that is assigned to the coupling interfaces 18.

The rotatable coupling member 40 comprises the coupling terminals 29 as at least one isolated terminal 42. In the failure state, the isolated terminal 42 is used for connecting the coupling interface 18 of the faulty amplifier stage 12 so as to galvanically separate the faulty amplifier stage 12 from the rest of the amplifier device 10.

The rotatable coupling member 40 may be rotated by the stepping motor 26.

The connection terminals 29 provided by the rotatable coupling member 40 may be assigned to coaxial interfaces, as an inner conductor 44 as well as an outer conductor 46 is provided by the connection terminal 29.

Thus, the coaxial lines 16 of the respective amplifier stags 12 may be connected with the rotatable coupling member 40.

The respective terminals 29, 42 provided by the rotatable coupling member 40 can be rotated about a centre M.

In general, each of the amplifier devices 10 shown in the different embodiments provide the functionality of separating the faulty amplifier stage 12 in a galvanic manner from the rest of the amplifier device 10.

Thus, a failure or rather error of at least one of the amplifier stages 12 is identified by means of the error-monitoring unit 20. The error-monitoring unit 20 further generates an error signal in order to indicate the occurrence of a respective failure.

Due to the error signal, the at least one faulty amplifier stage 12 can be separated galvanically from the rest of the amplifier device 10, for instance manually or rather in an automatic manner by controlling the switching unit 24.

For the automatic separation, the error-monitoring unit 20 may issue the error signal that is forwarded to the switching unit 24 configured to automatically separate the faulty amplifier stage 12 galvanically from the rest of the amplifier device 10, for instance by controlling the motor 26 appropriately.

The manual separation may be done by optically indicating the failure of the respective faulty amplifier stage 12 enabling the user to identify the error as well as the faulty amplifier stage 12. Then, the faulty amplifier stage 12 is galvanically separated from the rest of the amplifier device 10 by mechanically disconnecting the faulty amplifier stage 12.

In any case, the amplifier device 10 does not necessarily have to comprise a load resistance and a cooling assigned thereto, as the power processed by the faulty amplifier stage 12 is not directed to a load resistance, as a respective faulty amplifier stage 12 is galvanically separated from the amplifier device 10.

## Claims

1. A method of operating an amplifier device (10) having at least two parallel amplifier stages (12), with the following steps:
- Generating an error signal in case of failure of at least one amplifier stage (12) that is coupled to a rest of the amplifier device (10) via a coupling interface (18) in a releasable manner such that the amplifier stage (12) is galvanically separable from the rest of the amplifier device (10), wherein the error signal controls a switching unit (24) that comprises a stepping motor (26), and
- Separating the at least one faulty amplifier stage (12) galvanically from the rest of the amplifier device (10) by means of the stepping motor (26) causing a movement that provides the galvanic separation of the faulty amplifier stage (12) since a part of the amplifier stage (12) is moved by the stepping motor (26), wherein the part has the coupling interface (18).

2. The method according to claim 1, wherein occurrence of the error signal is optically indicated.

3. An amplifier device (10) comprising at least a first amplifier stage (12) and a second amplifier stage (12), wherein both amplifier stages (12) are parallel to each other, the amplifier device (10) comprising an error-monitoring unit (20) configured to monitor the status of the amplifier stages (12), wherein the error-monitoring unit (20) is further configured to generate an error signal in case of failure of at least one amplifier stage (12), and wherein the amplifier stages (12) each are coupled to a rest of the amplifier device (10) via a coupling interface (18) in a releasable manner such that the amplifier stages (12) are galvanically separable from the rest of the amplifier device (10), wherein the amplifier device (10) comprises a switching unit (24) that is assigned to at least one of the coupling interfaces (18), wherein the error signal controls the switching unit (24) that comprises a stepping motor (26) that is configured to cause a movement that provides the galvanic separation of the faulty amplifier stage (12) since a part of the amplifier stage (12) is moved by the stepping motor (26), wherein the part has the respective coupling interface (18).

4. The amplifier device (10) according to claim 3, wherein the switching unit (24) is connected with the error monitoring unit (20).

5. The amplifier device (10) according to claim 4, wherein the error monitoring unit (20) is configured to control the switching unit (24).

6. The amplifier device (10) according to any of claims 3 to 5, wherein the switching unit (24) comprises a rotatable coupling member (40) to which the coupling interfaces (18) are assigned.

7. The amplifier device (10) according to claim 6, wherein the coupling member (40) comprises an isolated terminal (42).

8. The amplifier device (10) according to any of claims 3 to 7, wherein at least one of the amplifier stages (12) comprises a line (16).

9. The amplifier device (10) according to claim 8, wherein the line (16) is a microstrip line.

10. The amplifier device (10) according to any of claims 3 to 7 and claim 8, wherein the switching unit (24) is assigned to the line (16) that is partially movable.

11. The amplifier device (10) according to claim 10, wherein the switching unit (24) is configured to move the partially movable line to galvanically separate the line from the rest of the amplifier device (10).

12. The amplifier device (10) according to any of claims 3 to 11, wherein the amplifier device (10) comprises an optical indication unit (22).

13. The amplifier device (10) according to claim 12, wherein the error monitoring unit (20) is connected with the optical indication unit (22).

14. The amplifier device (10) according to any of claims 3 to 13, wherein the amplifier device (10) is configured to perform a method according to any of the claims 1 to 2.

## Patentansprüche

1. Verfahren zum Betreiben einer Verstärkervorrichtung (10), die mindestens zwei parallele Verstärkerstufen (12) aufweist, mit den folgenden Schritten:
- Erzeugen eines Fehlersignals in einem Falle eines Ausfalls mindestens einer Verstärkerstufe (12), die derart mit einem Rest der Verstärkervorrichtung (10) über eine Kopplungsschnittstelle (18) auf lösbare Weise gekoppelt ist, dass die Verstärkerstufe (12) von dem Rest der Verstärkervorrichtung (10) galvanisch trennbar ist, wobei das Fehlersignal eine Schalteinheit (24) steuert, die einen Schrittmotor (26) umfasst, und
- Galvanisches Trennen der mindestens einen defekten Verstärkerstufe (12) von dem Rest der Verstärkervorrichtung (10), mittels des Schrittmotor (26), der eine Bewegung auslöst, die die galvanische Trennung der defekten Verstärkerstufe (12) bereitstellt, da ein Teil der Verstärkerstufe (12) durch den Schrittmotor (26) bewegt wird, wobei der Teil die Kopplungsschnittstelle (18) aufweist.

2. Verfahren nach Anspruch 1, wobei ein Auftreten des Fehlersignals optisch angezeigt wird.

3. Verstärkervorrichtung (10), umfassend mindestens eine erste Verstärkerstufe (12) und eine zweite Verstärkerstufe (12), wobei beide Verstärkerstufen (12) parallel zueinander sind, die Verstärkervorrichtung (10) umfassend eine Fehlerüberwachungseinheit (20), die konfiguriert ist, um den Status der Verstärkerstufen (12) zu überwachen, wobei die Fehlerüberwachungseinheit (20) ferner konfiguriert ist, um in einem Falle eines Ausfalls von mindestens einer Verstärkerstufe (12) ein Fehlersignal zu erzeugen, und wobei die Verstärkerstufen (12) jeweils mit dem Rest der Verstärkervorrichtung (10) über eine Kopplungsschnittstelle (18) auf lösbare Weise derart gekoppelt sind, dass die Verstärkerstufen (12) von dem Rest der Verstärkervorrichtung (10) galvanisch trennbar sind, wobei die Verstärkervorrichtung (10) eine Schalteinheit (24) umfasst, die mindestens einer der Kopplungsschnittstellen (18) zugeordnet ist, wobei das Fehlersignal die Schalteinheit (24) steuert, die einen Schrittmotor (26) umfasst, der konfiguriert ist, um eine Bewegung auszulösen, die die galvanische Trennung der defekten Verstärkerstufe (12) bereitstellt, da ein Teil der Verstärkerstufe (12) durch den Schrittmotor (26) bewegt wird, wobei der Teil die jeweilige Kopplungsschnittstelle (18) aufweist.

4. Verstärkervorrichtung (10) nach Anspruch 3, wobei die Schalteinheit (24) mit der Fehlerüberwachungseinheit (20) verbunden ist.

5. Verstärkervorrichtung (10) nach Anspruch 4, wobei die Fehlerüberwachungseinheit (20) konfiguriert ist, um die Schalteinheit (24) zu steuern.

6. Verstärkervorrichtung (10) nach einem der Ansprüche 3 bis 5, wobei die Schalteinheit (24) ein drehbares Kopplungselement (40) umfasst, dem die Kopplungsschnittstellen (18) zugeordnet sind.

7. Verstärkervorrichtung (10) nach Anspruch 6, wobei das Kopplungselement (40) einen isolierten Anschluss (42) umfasst.

8. Verstärkervorrichtung (10) nach einem der Ansprüche 3 bis 7, wobei mindestens eine der Verstärkerstufen (12) eine Leitung (16) umfasst.

9. Verstärkervorrichtung (10) nach Anspruch 8, wobei die Leitung (16) eine Mikrostreifenleitung ist.

10. Verstärkervorrichtung (10) nach einem der Ansprüche 3 bis 7 und Anspruch 8, wobei die Schalteinheit (24) der Leitung (16) zugeordnet ist, die teilweise bewegbar ist.

11. Verstärkervorrichtung (10) nach Anspruch 10, wobei die Schalteinheit (24) konfiguriert ist, um die teilweise bewegbare Leitung zu bewegen, um die Leitung von dem Rest der Verstärkervorrichtung (10) galvanisch zu trennen.

12. Verstärkervorrichtung (10) nach einem der Ansprüche 3 bis 11, wobei die Verstärkervorrichtung (10) eine optische Anzeigeeinheit (22) umfasst.

13. Verstärkervorrichtung (10) nach Anspruch 12, wobei die Fehlerüberwachungseinheit (20) mit der optischen Anzeigeeinheit (22) verbunden ist.

14. Verstärkervorrichtung (10) nach einem der Ansprüche 3 bis 13, wobei die Verstärkervorrichtung (10) konfiguriert ist, um ein Verfahren gemäß einem der Ansprüche 1 bis 2 durchzuführen.

## Revendications

1. Procédé de fonctionnement d'un dispositif amplificateur (10) ayant au moins deux étages d'amplification parallèles (12), avec les étapes suivantes consistant à :
- générer un signal d'erreur en cas de défaut d'au moins un étage d'amplification (12) qui est couplé à un reste du dispositif amplificateur (10) par l'intermédiaire d'une interface de couplage (18) de manière libérable de telle sorte que l'étage d'amplification (12) peut être séparé de manière galvanique du reste du dispositif amplificateur (10), dans lequel le signal d'erreur commande une unité de commutation (24) qui comprend un moteur pas à pas (26), et
- séparer de manière galvanique l'au moins un étage d'amplification défectueux (12) du reste du dispositif amplificateur (10) au moyen du moteur pas à pas (26) provoquant un mouvement qui produit la séparation galvanique de l'étage d'amplification défectueux (12) étant donné qu'une partie de l'étage d'amplification (12) est déplacée par le moteur pas à pas (26), dans lequel la partie possède l'interface de couplage (18).

2. Procédé selon la revendication 1, dans lequel l'apparition du signal d'erreur est indiquée de manière optique.

3. Dispositif amplificateur (10) comprenant au moins un premier étage d'amplification (12) et un second étage d'amplification (12), dans lequel les deux étages d'amplification (12) sont parallèles l'un à l'autre, le dispositif amplificateur (10) comprenant une unité de surveillance d'erreurs (20) configurée pour surveiller l'état des étages d'amplification (12), dans lequel l'unité de surveillance d'erreurs (20) est en outre configurée pour générer un signal d'erreur en cas de défaut d'au moins un étage d'amplification (12), et dans lequel les étages d'amplification (12) sont chacun couplés à un reste du dispositif amplificateur (10) par l'intermédiaire d'une interface de couplage (18) de manière libérable de telle sorte que les étages d'amplification (12) peuvent être séparés de manière galvanique du reste du dispositif amplificateur (10), dans lequel le dispositif amplificateur (10) comprend une unité de commutation (24) qui est affectée à au moins l'une parmi les interfaces de couplage (18), dans lequel le signal d'erreur commande l'unité de commutation (24) qui comprend un moteur pas à pas (26) qui est configuré pour provoquer un mouvement qui produit la séparation galvanique de l'étage d'amplification défectueux (12) étant donné qu'une partie de l'étage d'amplification (12) est déplacée par le moteur pas à pas (26), dans lequel la partie possède l'interface de couplage respective (18).

4. Dispositif amplificateur (10) selon la revendication 3, dans lequel l'unité de commutation (24) est connectée à l'unité de surveillance d'erreurs (20).

5. Dispositif amplificateur (10) selon la revendication 4, dans lequel l'unité de surveillance d'erreurs (20) est configurée pour commander l'unité de commutation (24).

6. Dispositif amplificateur (10) selon l'une quelconque des revendications 3 à 5, dans lequel l'unité de commutation (24) comprend un élément de couplage rotatif (40) auquel les interfaces de couplage (18) sont affectées.

7. Dispositif amplificateur (10) selon la revendication 6, dans lequel l'élément de couplage (40) comprend une borne isolée (42).

8. Dispositif amplificateur (10) selon l'une quelconque des revendications 3 à 7, dans lequel au moins l'un parmi les étages d'amplification (12) comprend une ligne (16).

9. Dispositif amplificateur (10) selon la revendication 8, dans lequel la ligne (16) est une ligne microruban.

10. Dispositif amplificateur (10) selon l'une quelconque des revendications 3 à 7 et la revendication 8, dans lequel l'unité de commutation (24) est affectée à la ligne (16) qui est partiellement mobile.

11. Dispositif amplificateur (10) selon la revendication 10, dans lequel l'unité de commutation (24) est configurée pour déplacer la ligne partiellement mobile pour séparer de manière galvanique la ligne du reste du dispositif amplificateur (10).

12. Dispositif amplificateur (10) selon l'une quelconque des revendications 3 à 11, dans lequel le dispositif amplificateur (10) comprend une unité d'indication optique (22).

13. Dispositif amplificateur (10) selon la revendication 12, dans lequel l'unité de surveillance d'erreurs (20) est connectée à l'unité d'indication optique (22).

14. Dispositif amplificateur (10) selon l'une quelconque des revendications 3 à 13, dans lequel le dispositif amplificateur (10) est configuré pour mettre en œuvre un procédé selon l'une quelconque des revendications 1 à 2.
